Europäisches Patentamt

European Patent Office

Office européen des brevets

(19)

(11) EP 0 549 449 B1

(12) **FASCICULE DE BREVET EUROPEEN**

(45) Date de publication et mention
de la délivrance du brevet:
**27.03.1996 Bulletin 1996/13**

(51) Int Cl.$^6$: **C30B 11/00**, C30B 13/28,
C30B 15/20, G01N 25/06

(21) Numéro de dépôt: **92403497.8**

(22) Date de dépôt: **21.12.1992**

(54) **Dispositif de solidification d'un matériau conducteur de l'électricité dopé et de contrôle en continu de sa teneur en dopant**

Vorrichtung zum Erstarren von dotiertem, elektrisch leitenden Material und zur kontinuierlichen Überwachung der Konzentration des Dotierstoffes

Apparatus for solidifying a doped electrically conducting material and for continuously monitoring its dopant concentration

(84) Etats contractants désignés:
**CH DE GB IT LI NL**

(30) Priorité: **23.12.1991 FR 9115995**

(43) Date de publication de la demande:
**30.06.1993 Bulletin 1993/26**

(73) Titulaires:
- **COMMISSARIAT A L'ENERGIE ATOMIQUE**
  **F-75015 Paris (FR)**
- **CENTRE NATIONAL D'ETUDES SPATIALES**
  **F-75001 Paris (FR)**

(72) Inventeurs:
- **Comera, Jean**
  **F-38610 Gieres (FR)**
- **Favier, Jean-Jacques**
  **F-38000 Grenoble (FR)**

- **Rouzaud, André**
  **F-38170 Seyssinet (FR)**

(74) Mandataire: **Dubois-Chabert, Guy et al**
**c/o BREVATOME**
**25, rue de Ponthieu**
**F-75008 Paris (FR)**

(56) Documents cités:
DD-A- 222 046          DE-B- 1 798 222
FR-A- 2 597 884

- **METALLURGICAL TRANSACTIONS A. PHYSICAL METALLURGY&& MATERIALS vol. 22A, no. 6, Juin 1991, NEW YORK US pages 1259 - 1270 S.D. PETEVES ET AL: 'Growth kinetics of solid-liquid Ga interfaces: Part I. Experimental'**
- **MATERIALS RESEARCH SOCIETY SYMPOSIA PROCEEDINGS vol. 53, 1986, PITTSBURGH US pages 323 - 328 S.D. PETEVES ET AL: 'A technique for in-situ detection of growth dislocations'**

EP 0 549 449 B1

## Description

DISPOSITIF DE SOLIDIFICATION D'UN MATERIAU CONDUCTEUR DE L'ELECTRICITE DOPE ET DE CONTROLE EN CONTINU DE SA TENEUR EN DOPANT

La présente invention a pour objet un dispositif de solidification d'un matériau conducteur de l'électricité dopé, à partir d'un liquide, permettant le contrôle en continu de la teneur en dopant du matériau.

L'invention s'applique en cristallogénèse pour toute croissance d'un monocristal inorganique dopé semi-conducteur ou conducteur. Les matériaux conducteurs sont en particulier des matériaux métalliques.

Le dispositif de l'invention s'applique aussi aux alliages métalliques, par exemple aux superalliages à base de Ni, Cu ou Zn.

Le dopant peut être une impureté introduite dans le cristal (du phosphore ou du bore dans un cristal de silicium, du gallium dans un cristal de germanium, du fer dans un cristal de GaAs, etc.) ou un élément de substitution (par exemple de l'indium dans un cristal de $Ga_{1-x}$ $In_x$ Sb avec $0<x\leq1$, le mercure dans un cristal de $Cd_{1-y}$ $Hg_y$ Te avec $0<y\leq1$). Par ailleurs, le dopant peut représenter de 0,01% à 99,99% en poids du cristal.

Aussi, l'invention s'applique par exemple dans le domaine de la métallurgie pour l'élaboration de tout alliage dont les propriétés d'usage (mécanique, thermique, électrique) dépendent de la structure fine de cet alliage, dans le domaine de la microélectronique, de l'optique intégrée, des lasers à cristal, etc.

La croissance cristalline à partir d'un bain fondu est la méthode la plus utilisée pour élaborer des cristaux métalliques ou semi-conducteurs de bonne qualité.

Les propriétés les plus recherchées sont la qualité structurale ou cristalline et l'homogénéité de composition. Les méthodes de croissance cristalline les plus répandues sont les méthodes de tirage Czochralski, de fusion de zone, de zone flottante ou encore les méthodes de Bridgman ou de Stockbarger horizontales ou verticales.

De façon plus précise, l'invention se rapporte à la solidification d'un monocristal selon les méthodes de Bridgman ou de Stockbarger tant dans leur réalisation terrestre que spatiale.

Actuellement, une seule méthode permet de mesurer en continu la composition d'un solide en matériau opaque (semi-conducteur métallique) pendant son élaboration sans perturber sa croissance.

Cette méthode est décrite dans les documents FR-A-2 597 884 et US-A-4 797 174.

Le procédé décrit dans ces références autorise une mesure en continu de la qualité chimique du cristal formé. Ainsi, il est possible d'agir rétroactivement sur les causes de défaut dans le cristal et d'obtenir ainsi un solide de qualités améliorées. Ce procédé est basé sur la mesure de la différence de température entre la température d'une interface mobile solide/liquide et la température d'une interface fixe solide/liquide d'un même alliage à une composition déterminée.

Ce type de mesure exige un dispositif lourd et complexe qui en limite les applications tant au sol que dans l'espace. En particulier, ce dispositif comporte deux fours juxtaposés et deux systèmes de refroidissement rendant le dispositif encombrant, la puissance électrique consommée importante et par conséquent entraînant un prix de revient onéreux. De plus, ce dispositif présente une difficulté, voire une impossibilité de réalisation spatiale, lorsque l'énergie et la puissance disponibles sont limitées.

Les autres procédés de croissance actuellement connus ne présentent aucune rétroaction ou contrôle en continu, ce qui ne permet pas une optimisation des matériaux formés.

Aussi, l'invention a pour objet un dispositif de solidification d'un matériau conducteur dopé permettant de remédier aux différents inconvénients mentionnés ci-dessus. En particulier, ce dispositif permet la mesure en continu de la teneur en dopant du matériau tout en présentant une réalisation pratique beaucoup plus simple, un encombrement et un prix de revient plus faibles que ceux de l'art antérieur.

De façon plus précise, l'invention a pour objet un dispositif de solidification d'un matériau conducteur de l'électricité et dopé par un dopant et de contrôle en continu de la teneur en dopant de ce matériau, comportant :

- des premiers moyens pour former un liquide dudit matériau non dopé en équilibre thermodynamique avec un solide dudit matériau non dopé,
- des seconds moyens pour former un liquide dudit matériau dopé en équilibre thermodynamique avec un solide dudit matériau dopé,
- des moyens pour mettre en court-circuit électrique le liquide non dopé et le liquide dopé, et
- des moyens pour mesurer une différence de potentiel électrique entre le solide non dopé et le solide dopé, cette différence de potentiel étant représentative de la teneur en dopant à l'interface liquide dopé-solide dopé.

Le matériau solide obtenu est un monocristal.

Par matériau conducteur de l'électricité, il faut comprendre aussi bien un matériau conducteur qu'un matériau semi-conducteur.

Par dopant, il faut comprendre aussi bien des impuretés qu'un élément de substitution d'un élément du matériau par un autre.

En outre, par dopé, il faut comprendre une concentration en dopant pouvant représenter de 0,01% à 49,99% en poids du cristal ; le dopant est toujours la phase minoritaire du cristal.

Pour un composé déterminé, pur ou dopé, la température d'équilibre des phases liquide et solide est nommée température de fusion. On la note $T_f$.

Au cours de la solidification, le front de solidification (c'est-à-dire l'interface séparant le liquide du solide) se trouve en état de surfusion. Autrement dit, la température de l'interface, notée $T_I$, est inférieure à la température de fusion/solidification du matériau.

La température $T_I$ du front de solidification est donc égale à la température $T_f - \Delta T$ où $\Delta T$ représente la surfusion.

La surfusion d'un composé pur, notée $\Delta T_p$, est très faible comparée à celle du composé dopé, notée $\Delta T_d$.

En particulier, $\Delta T_d$ est très supérieur à $\Delta T_p$ (généralement 10 à $10^6$ fois plus élevé selon la concentration, la vitesse ...), $\Delta T_p$ étant voisin de 0.

Selon un mode pratique de mise en oeuvre, on utilise deux creusets distincts pour recevoir respectivement le matériau dopé et le matériau non dopé. Ainsi, les premiers moyens comprennent : un premier creuset de forme allongée pour recevoir le matériau non dopé ; des premiers moyens de chauffage pour chauffer une première partie dudit premier creuset et y former ledit liquide non dopé et des premiers moyens de refroidissement pour refroidir une seconde partie dudit premier creuset et y former ledit solide non dopé et les seconds moyens comprennent : un second creuset de forme allongée pour recevoir le matériau dopé des seconds moyens de chauffage pour chauffer une première partie dudit second creuset et y former ledit liquide dopé et des seconds moyens de refroidissement pour refroidir une seconde partie dudit second creuset et y former ledit solide dopé.

Dans un dispositif où les matériaux dopés et non dopés sont soumis à un déplacement relatif par rapport aux moyens de chauffage, la surfusion $\Delta T_p$ du composé pur est d'origine cinétique et celle $\Delta T_d$ du composé dopé est à la fois d'origine chimique et cinétique.

On peut montrer que, si v est le coefficient thermoélectrique Seebec à l'interface liquide-solide, la différence de potentiel $\Delta V$ entre le solide dopé et le solide non dopé satisfait à l'équation (1) :

$$(1) \qquad \Delta V = v \times \Delta T + C_1,$$

où $C_1$ est une constante fonction :

- de la différence des coefficients thermoélectriques des solides purs et dopés, de la différence des coefficients thermoélectriques des liquides purs et dopés,
- des températures des deux contacts électriques avec le solide et des deux contacts électriques avec le liquide des moyens de mesure.

Cette équation (1) est vraie à condition que les températures du solide dopé et du solide non dopé soient connues ou égales et que les coefficients thermoélectriques du solide et du liquide varient très peu avec la teneur en dopant.

Par ailleurs, on peut , montrer que la surfusion $\Delta T$ est directement liée à la concentration C de dopant à l'interface solide dopé/liquide dopé.

Ainsi, $\Delta V$ permet de mesurer en continu la teneur en dopant du cristal en formation et de réagir, si nécessaire, au cours de la croissance sur les paramètres de solidification comme par exemple les températures de chauffage des liquides et de refroidissement des solides, les vitesses de déplacement relatives des matériaux par rapport aux systémes de chauffage et de refroidissement afin d'adapter la concentration en dopant aux besoins de l'utilisateur.

Le procédé de l'invention permet donc d'obtenir un solide dans lequel le profil de dopant, suivant la direction de croissance, est adapté aux besoins de l'utilisateur. Il permet ainsi d'éviter les irrégularités entraînées par des variations accidentelles des conditions de solidification et donc d'obtenir des produits de meilleures qualités que ceux de l'art antérieur.

Le principe de la mesure utilisé dans l'invention est différent de celui utilisé dans les documents FR-A-2 597 884 et US-A-4 797 174. En particulier, il est basé sur l'utilisation de deux interfaces mobiles, l'une relative au composé dopé et l'autre relative au composé pur (ou non dopé). Ceci permet d'obtenir un certain nombre d'avantages.

En particulier, la température de référence $T_f$ qui permet la mesure de la surfusion dT est ici une constante physique puisqu'elle correspond à la température de fusion du composé pur. Ceci élimine une cause d'erreur existant dans le procédé antérieur, qui est la variation, non maîtrisée, de la température de référence.

En effet, cette dernière dépend de mouvements convectifs présents dans le liquide et plus particulièrement des mouvements convectifs proches de l'interface de référence (c'est-à-dire du corps pur).

Par ailleurs, le dispositif de l'invention est beaucoup plus simple que celui de l'art antérieur. En particulier, les moyens de chauffage des creusets peuvent consister en un seul et même four.

De même, les moyens de refroidissement des matériaux dopé et non dopé peuvent consister en seul et même système de refroidissement.

Ainsi, l'ensemble thermique (four, système de refroidissement, dispositif de fourniture d'énergie au four et au système de refroidissement) ainsi que l'électronique de commande et de régulation sont deux fois moins importants et moins onéreux que ceux de l'art antérieur. Par ailleurs, l'énergie thermique et la puissance maximale nécessaires sont deux fois plus faibles, toute chose égale par ailleurs.

En outre, la longueur du dispositif et sa masse sont réduites de moitié par rapport au dispositif de l'art antérieur.

Ainsi, le dispositif de l'invention est parfaitement bien adapté à une application spatiale où l'énergie, la puissance maximale, le poids et l'encombrement sont limités.

De façon avantageuse, les points de mesure de la différence de potentiel dans le solide dopé et le solide non dopé sont très proches, ce qui facilite leur maintien à une même température.

Le dispositif de l'invention est un appareil de type Bridgman ou Stockbarger comportant une simple modification du creuset.

D'autres caractéristiques et avantages de l'invention ressortiront mieux de la description qui va suivre, donnée à titre illustratif et non limitatif, en référence aux figures annexées dans lesquelles :

- la figure 1 illustre schématiquement le dispositif de l'invention pour une solidification verticale du type Bridgman,
- la figure 2 est un graphique montrant le profil longitudinal de température à l'intérieur du dispositif de la figure 1,
- la figure 3 donne le diagramme de phase composé pur-dopant, c'est-à-dire les variations de la température de fusion $T_f$ en fonction de la concentration C en dopant dans le composé.

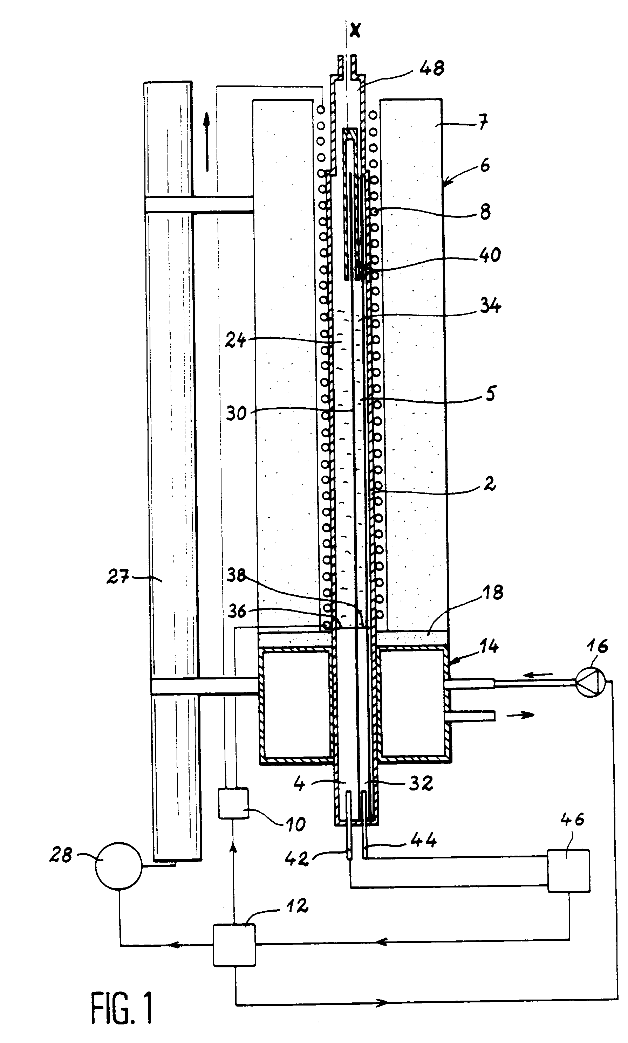

Comme tout dispositif Bridgman ou Stockbarger vertical, le dispositif représenté sur la figure 1 comporte un creuset 2 de forme cylindrique, de diamètre inférieur à sa hauteur, destiné à contenir le cristal 4 dopé à élaborer. X représente l'axe longitudinal du creuset 2.

Ce dispositif comporte de plus un four 6 à symétrie axiale, équipé de résistances chauffantes 8 (de 500W par exemple de puissance de chauffe), alimentées en courant par une source d'alimentation électrique continue 10. L'alimentation en courant 10 est contrôlée par un circuit de traitement du type micro-ordinateur 12.

Un manchon 7 isolant électrique et thermique est prévu pour entourer les éléments chauffants 8.

Ce dispositif comporte en outre un système de refroidissement 14 du type à circulation d'eau, placé en-dessous du four 6 et dans son prolongement.

Le système de circulation d'eau 14 est équipé d'une électrovanne 16, commandée aussi par le dispositif de traitement 12.

Afin de bien séparer les zones de refroidissement de celles de chauffage, une couronne 18 isolante thermiquement est prévue entre le four 6 et le système de refroidissement 14.

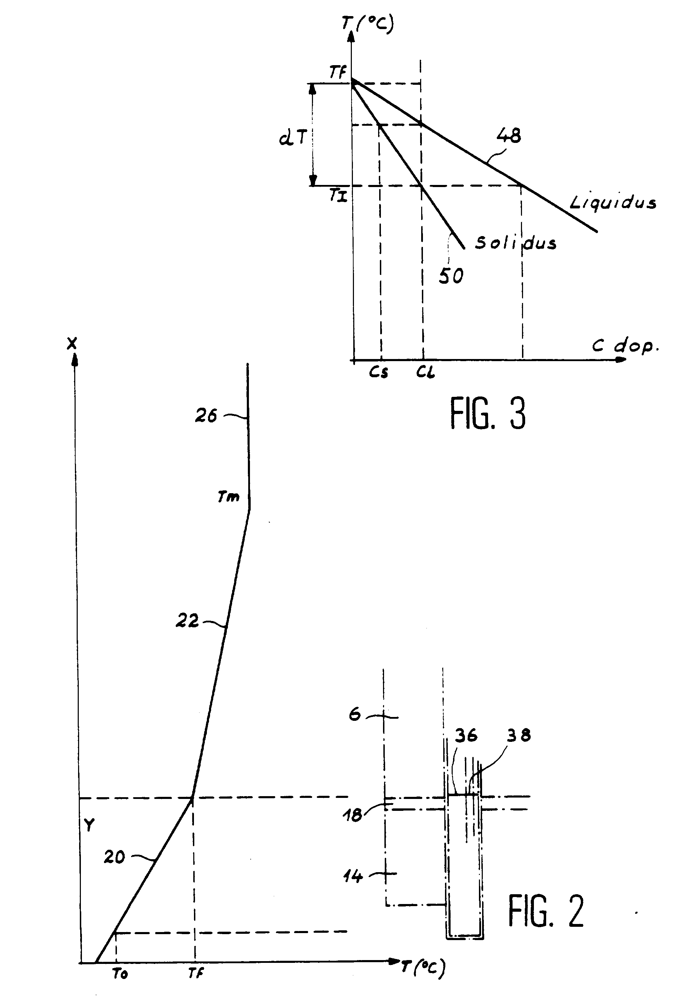

L'ensemble four 6, couronne 18 isolante et système de refroidissement 14 de l'invention permet la réalisation d'un gradient de températures longitudinal, selon l'axe X de symétrie du creuset 2, tel que représenté sur la figure 2.

Le profil de températures de la figure 2 comporte une partie inférieure 20 correspondant à une augmentation régulière de la température du matériau solide dopé 4. Dans cette zone 20, la température passe de la température $T_o$ de refroidissement à la température $T_f$ de fusion. Cette température $T_o$ est voisine de 20°C (ou température ambiante).

Le profil de la figure 2 comporte par ailleurs une partie intermédiaire 22 correspondant à une augmentation régulière de la température en partant de la température de fusion $T_f$ pour arriver à la température maximale $T_m$ de chauffage à laquelle est soumis le matériau. $T_m$ est supérieur à la température de fusion et permet l'obtention d'un liquide dopé 24 en équilibre thermodynamique avec le solide 4 dopé à fabriquer.

Cette température $T_m$ est maintenue sur toute la partie supérieure du four ; c'est ce que représente la partie verticale 26 de la courbe 2.

L'ensemble système de refroidissement 14-couronne isolante 18 et four 6 est solidaire d'un support 27 équipé de rails de guidage et d'un moteur 28 permettant une translation selon l'axe X de l'ensemble 14-18-6, le creuset 2 restant fixe. La mise en route du moteur 28 est pilotée aussi par le micro-ordinateur 12.

Conformément à l'invention, on trouve, de plus, un second creuset 30 de forme cylindrique, logé à l'intérieur du creuset 2 présentant un diamètre inférieur à celui du creuset 2. Ce creuset 30 se présente sous la forme d'un tube orienté selon l'axe X de symétrie du creuset 2. Il est solidaire du creuset 2.

Ce creuset interne 30 est rempli d'un composé identique à celui à élaborer, mais exempt de dopant.

L'ensemble four-couronne isolante-système de refroidissement permet d'une part l'obtention du solide dopé 4 en équilibre thermodynamique avec son liquide dopé 20 ainsi que l'obtention d'un solide pur 32 en équilibre thermodynamique avec son liquide non dopé 34.

Les références 36 et 38 indiquent respectivement l'interface solide dopé/liquide dopé et solide non dopé/liquide non dopé.

Dans le cas de très faibles concentrations en dopant, ces deux interfaces 36 et 38 sont à des cotes très voisines du fait que les températures de fusion du composé pur (ou non dopé) et du composé dopé sont peu différentes.

La solidification étant effectuée en déplaçant l'ensemble four-couronne-système de refroidissement par rapport aux creusets 2 et 30 ainsi, les deux interfaces 36 et 38 solide/liquide progressent simultanément jusqu'à la solidification complète des composés pur et dopé.

Conformément à l'invention, et pendant toute la durée de la solidification, les deux liquides 24 dopé et 34 non dopé sont court-circuités électriquement par un pont conducteur 40 ayant la forme d'une épingle à cheveux dont chaque branche plonge dans un liquide. Le pont 40 est réalisé en un matériau insoluble dans ces liquides et inerte chimiquement vis-à-vis de ces liquides.

D'autre part, le solide dopé 4 et le solide non dopé 32 sont équipés d'un contact électrique respectivement 42, 44. Ces contacts électriques sont situés en particulier dans la zone la plus froide de ces solides, c'est-à-dire à leur extrémité inférieure.

Un système 46 permet de mesurer la différence de potentiel apparaissant entre les contacts électriques 42 et 44. Le signal électrique fourni par ce système de mesure 46 est envoyé vers le micro-ordinateur 12 qui, selon la différence de potentiel mesurée, modifie ou non la vitesse de déplacement de l'ensemble four-couronne-système de refroidissement, via le moteur 28, la tension d'alimentation des éléments chauffants 8 du four, via la source d'alimentation électrique 10, ou encore le débit du liquide de refroidissement, via l'ouverture et la fermeture de l'électrovanne 16, pour modifier le profil de températures du système.

Une enceinte 48 montée au sommet du creuset externe 2 permet, si nécessaire, la mise sous vide des creusets ou l'introduction d'un gaz inerte ou réactif au-dessus des liquides 24 et 34.

La hauteur totale du dispositif de l'invention est environ deux fois plus faible que celle des dispositifs de l'art antérieur.

De plus, le dispositif pèse 1,7 fois moins que celui de l'art antérieur et consomme 1,8 fois moins d'énergie que celui de l'art antérieur.

Si l'on désigne par $C_l$ et $C_s$ la concentration du dopant respectivement dans le liquide 24 dopé et le solide 4 dopé, à l'interface 36 et m la pente de la courbe 48 de liquidus du diagramme de phase du composé pur-dopant, tel que représenté sur la figure 3, et $K_o$ le coefficient de partage thermodynamique du dopant dans le composé pur, il s'ensuit, pour des systèmes dont le coefficient Seebeck ne dépend pas de la concentration du composé, que $\Delta V = C_2 + (v_{ld} - v_{sd}) \times m \times C_s / K_o$ avec $v_{ld}$ et $v_{sd}$ respectivement le coefficient Seebeck du liquide dopé et le coefficient Seebeck du solide dopé et $C_2$ une constante fonction des coefficients thermoélectriques des phases en présence. Autrement dit, $\Delta V = C_3 + C_4 \times C_s$ avec $C_3$ et $C_4$ des constantes dépendant du matériau à élaborer.

Ainsi, la différence de potentiel dV mesurée est proportionnelle à la concentration $C_s$ de dopant dans le solide 4 dopé et le contrôle de cette dernière est aisé.

Sur la figure 3, on a aussi représenté la courbe 50 de solidus et la surfusion $\Delta T$ entre la température de fusion $T_f$ et la température $T_l$ de l'interface 36 solide dopé-liquide dopé.

Le dispositif de l'invention a été appliqué à la croissance de germanium dopé au gallium à une concentration en 0,5% en poids.

Ainsi, le solide dopé 4 et le liquide dopé 24 sont respectivement en germanium dopé au gallium ; le solide pur 32 et le liquide pur 34 en équilibre avec ce dernier sont en germanium pur ; le court-circuit électrique 40 entre les deux liquides est en tungstène ou carbone et les creusets 2 et 30 sont en silice ou en alumine. Les températures $T_o$, $T_f$ et $T_m$ sont respectivement 20°C, 937°C et 1100°C.

**Revendications**

1. Dispositif de solidification d'un matériau conducteur de l'électricité et dopé par un dopant et de contrôle en continu de la teneur en dopant de ce matériau, comportant :

    - des premiers moyens (30, 6, 14) pour former un liquide (34) dudit matériau non dopé en équilibre thermodynamique avec un solide dudit matériau non dopé (32),
    - des seconds moyens (2, 6, 14) pour former un liquide dudit matériau dopé (24) en équilibre thermodynamique avec un solide dudit matériau dopé (4), et
    - des moyens (40) pour mettre en court-circuit électrique le liquide non dopé (34) et le liquide dopé (24),
    - des moyens (42, 44, 46) pour mesurer une différence de potentiel électrique entre le solide non dopé (32) et le solide dopé (4), cette différence de potentiel étant représentative de la teneur en dopant à l'interface liquide dopé-solide dopé.

2. Dispositif selon la revendication 1, caractérisé en ce que les premiers moyens comprennent un premier creuset (30) destiné à recevoir le matériau non dopé et les seconds moyens comprennent un second creuset (2), distinct du premier, destiné à recevoir le matériau dopé.

3. Dispositif selon la revendication 1 ou 2, caractérisé en ce que les premiers moyens comprennent : un premier creuset (30) de forme allongée pour recevoir le matériau non dopé ; des premiers moyens de chauffage (6) pour chauffer une première partie dudit premier creuset et y former ledit liquide non dopé (34) et des premiers moyens de refroidissement (14) pour refroidir une seconde partie dudit premier creuset et y former ledit solide non dopé (32) et en ce que les seconds moyens comprennent : un second creuset (2) de forme allongée pour recevoir le matériau dopé ; des seconds moyens de chauffage (6) pour chauffer une première partie dudit second creuset et y former ledit liquide dopé (24) et des seconds moyens de refroidissement (14) pour refroidir une seconde partie dudit second creuset et y former ledit solide dopé (4).

4. Dispositif selon la revendication 3, caractérisé en ce que les premiers moyens de chauffage et les seconds moyens de chauffage consistent en un seul et même four (6).

5. Dispositif selon la revendication 3 ou 4, caractérisé en ce que les premiers moyens de refroidissement et les seconds moyens de refroidissement consistent en un seul et même système de refroidissement (14).

6. Dispositif selon l'une quelconque des revendications 2 à 5, caractérisé en ce que le premier creuset (30) est logé dans le second creuset (2) et solidaire dudit second creuset.

7. Dispositif selon l'une quelconque des revendications 3 à 6, caractérisé en ce que des moyens (27, 28) sont prévus pour effectuer un mouvement de déplacement relatif entre le premier creuset (30) et les premiers moyens de chauffage (6) et entre le second creuset (2) et les seconds moyens de chauffage (6).

8. Dispositif selon les revendications 4 et 5, caractérisé en ce que le four (6) et le système de refroidissement (14) sont disposés l'un au-dessus de l'autre et en ce que des moyens isolants thermiques (18) sont prévus entre le four et le système de refroidissement.

9. Dispositif selon l'une quelconque des revendications 1 à 8, caractérisé en ce que les moyens (40) pour mettre en court-circuit les liquides dopé et non dopé consistent en un pont conducteur dont les extrémités plongent respectivement dans le liquide dopé et le liquide non dopé, ce pont étant inerte chimiquement vis-à-vis des liquides dopé et non dopé et non soluble dans ces liquides.

10. Dispositif selon l'une quelconque des revendications 1 à 9, caractérisé en ce que les points de mesure de la différence de potentiel dans le solide dopé et le solide non dopé sont très proches.

**Patentansprüche**

1. Vorrichtung zum Erstarren eines elektrisch leitenden und durch einen Dotierstoff dotierten Materials und zur kontinuierlichen Überwachung der Dotierstoffkonzentration dieses Materials, umfassend:

   - erste Einrichtungen (30, 6, 14) zum Bilden einer nichtdotierten Flüssigkeit (34) aus besagtem Material, im thermodynamischen Gleichgewicht mit einem nichtdotierten festen Körper aus besagtem Material (32),
   - zweite Einrichtungen (2, 6, 14) zum Bilden einer dotierten Flüssigkeit (24) aus besagtem Material, im thermodynamischen Gleichgewicht mit einem dotierten festen Körper aus besagtem Material (4), und
   - Einrichtungen (40), um die nicht dotierte Flüssigkeit (34) und die dotierte Flüssigkeit (24) elektrisch kurzzuschließen,
   - Einrichtungen (42, 44, 46) zum Messen eines elektrischen Potentialunterschieds zwischen dem nichtdotierten festen Körper (32) und dem dotierten festen Körper (4), wobei diese Potentialdifferenz repräsentativ ist für die Dotierstoffkonzentration an der Grenzschicht zwischen der dotierten Flüssigkeit und dem dotierten festen Körper.

2. Vorrichtung nach Anspruch 1, dadurch gekennzeichnet, daß die ersten Einrichtungen einen ersten Tiegel (30) zum Aufnehmen des nichtdotierten Materials umfassen, und die zweiten Einrichtungen einen zweiten Tiegel (2) umfassen, verschieden vom ersten, zum Aufnehmen des dotierten Materials.

3. Vorrichtung nach Anspruch 1 oder 2, dadurch gekennzeichnet, daß die ersten Einrichtungen umfassen: einen ersten Tiegel (30) von länglicher Form, um das nichtdotierte Material aufzunehmen; erste Heizeinrichtungen (6), um einen ersten Teil des ersten Tiegels zu heizen und darin besagte nichtdotierte Flüssigkeit (34) zu bilden, und erste Kühleinrichtungen (14), um einen zweiten Teil des ersten Tiegels zu kühlen und darin besagten nichtdotierten festen Körper (32) zu bilden, und dadurch, daß die zweiten Einrichtungen umfassen: einen zweiten Tiegel (2) von länglicher Form, um das dotierte Material aufzunehmen; zweite Heizeinrichtungen (6), um einen ersten Teil des zweiten Tiegels zu heizen und darin besagte dotierte Flüssigkeit (24) zu bilden, und zweite Kühleinrichtungen (14), um einen zweiten Teil des zweiten Tiegels zu kühlen und darin besagten dotierten festen Körper (4) zu bilden.

4. Vorrichtung nach Anspruch 3, dadurch gekennzeichnet, daß die ersten Heizeinrichtungen und die zweiten Heizeinrichtungen aus ein und demselben Ofen (6) bestehen.

5. Vorrichtung nach Anspruch 3 oder 4, dadurch gekennzeichnet, daß die ersten Kühleinrichtungen und die zweiten Kühleinrichtungen aus ein und demselben Kühlsystem (14) bestehen.

6. Vorrichtung nach einem der Ansprüche 2 bis 5, dadurch gekennzeichnet, daß der erste Tiegel (30) in einem zweiten Tiegel (2) untergebracht und fest verbunden ist mit diesem zweiten Tiegel.

7. Vorrichtung nach einem der Ansprüche 3 bis 6, dadurch gekennzeichnet, daß Einrichtungen (27, 28) vorgesehen sind, um eine Relativverschiebebewegung zwischen dem ersten Tiegel (30) und den ersten Heizeinrichtungen (6) und zwischen dem zweiten Tiegel (2) und den zweiten Heizeinrichtungen (6) auszuführen.

8. Vorrichtung nach einem der Ansprüche 4 und 5, dadurch gekennzeichnet, daß der Ofen (6) und das Kühlsystem (14) übereinander angeordnet sind, und daß thermische Isolationseinrichtungen (18) vorgesehen sind zwischen dem Ofen und dem Kühlsystem.

9. Vorrichtung nach einem der Ansprüche 1 bis 8, dadurch gekennzeichnet, daß die Einrichtungen (40) zum Kurzschließen der dotierten und nichtdotierten Flüssigkeiten aus einer leitenden Brücke besteht, deren Enden jeweils in die dotierte Flüssigkeit und die nichtdotierte Flüssigkeit eintauchen, wobei diese Brücke chemisch inert ist gegenüber dotierten und nichtdotierten Flüssigkeiten und nicht lösbar ist in diesen Flüssigkeiten.

10. Vorrichtung nach einem der Ansprüche 1 bis 9, dadurch gekennzeichnet, daß die Meßpunkte der Potentialdifferenz in dem dotierten festen Körper und dem nichtdotierten festen Körper nahe beieinander liegen.

**Claims**

1. Apparatus for the solidification of an electricity conducting material doped by a dopant and for the continuous checking of the dopant content of said material comprising first means (30, 6, 14) for forming a liquid (34) of said undoped material in thermodynamic equilibrium with a solid of said undoped material (32), second means (2, 6, 14) for forming a liquid of said doped material (4) in thermodynamic equilibrium with a solid of said doped material (4), means (40) for electrically short-circuiting the undoped liquid (34) and the doped liquid (24) and means (42, 44, 46) for measuring an electric potential difference between the undoped solid (32) and the doped solid (4), said potential difference representing the dopant content at the doped solid-doped liquid interface.

2. Apparatus according to claim 1, characterized in that the first means comprise a first crucible (30) for receiving the undoped material and the second means comprise a second crucible (2), separate from the first and for receiving the doped material.

3. Apparatus according to claim 1 or 2, characterized in that the first means comprise a first elongated crucible (30) for receiving the undoped material, first heating means (6) for heating a first part of said first crucible and for forming therein said undoped liquid (34) and first cooling means (14) for cooling a second part of said first crucible and forming therein said undoped solid (32) and the second means comprise a second elongated crucible (2) for receiving the doped material, second heating means (6) for heating a first part of said crucible and forming therein said doped liquid (24) and second cooling means (14) for cooling a second part of said second crucible and for forming therein said doped solid (4).

4. Apparatus according to claim 3, characterized in that the first heating means and the second heating means comprise one and the same furnace (6).

5. Apparatus according to claim 3 or 4, characterized in that the first cooling means and the second cooling means comprise a single cooling system (14).

6. Apparatus according to any one of the claims 2 to 5, characterized in that the first crucible (30) is located in the second crucible (2) and is integral with the latter.

7. Apparatus according to any one of the claims 3 to 6, characterized in that means (27, 28) are provided for bringing about a relative displacement movement between the first crucible (30) and the first heating means (6) and between the second crucible (2) and the second heating means (6).

8. Apparatus according to claims 4 and 5, characterized in that the furnace (6) and the cooling system (14) are positioned one above the other and that the thermal insulating means (18) are located between the furnace and the cooling system.

9. Apparatus according to any one of the claims 1 to 9, characterized in that the means (40) for short-circuiting the doped and undoped liquids comprise a conductor bridge, whose ends are respectively immersed in the doped liquid and the undoped liquid, said bridge being chemically inert relative to the doped and undoped liquids and insoluble in said liquids.

10. Apparatus according to any one of the claims 1 to 9, characterized in that the measurement points of the potential difference in the doped solid and the undoped solid are very close together.

FIG. 1

FIG. 3

FIG. 2